# EUROPÄISCHE PATENTANMELDUNG

(11) **EP 4 407 857 A1**
(43) Veröffentlichungstag der Anmeldung: **31.07.2024**
(21) Anmeldenummer: 23153206.0
(22) Anmeldetag: 25.01.2023
(51) Int. Cl.: H02M 7/5387, H02M 1/00, H02M 3/158, H02M 7/00, H02P 25/22, H02K 11/33

(54) **ENERGIEVERSORGUNG FÜR EINEN MULTIPHASENANTRIEB**

(71) Anmelder: Siemens Aktiengesellschaft, 80333 München (DE)
(72) Erfinder: Brandl, Konrad, 93107 Thalmassing (DE); Robinson, Jonathan, 90489 Nürnberg (DE)
(74) Vertreter: Siemens Patent Attorneys

(57) **Zusammenfassung**

Die Erfindung betrifft eine Energieversorgungsvorrichtung (1) für einen Multiphasenantrieb (10), wobei der Multiphasenantrieb (10) eine Eingangsspannung von weniger als 100 V und eine Nennleistung von mehr als 300 kW, insbesondere von mehr als 1 MW, 300 kW, insbesondere von mehr als 1 MW, aufweist. Zur Verbesserung der Energieversorgung für einen derartigen Multiphasenantrieb (10) wird vorgeschlagen, dass die Energieversorgungeinrichtung (1) einen Spannungsumformer (4) aufweist, wobei die Energieversorgungsvorrichtung (1) einen Leitungsstreckenabschnitt (3) zur Übertragung von elektrischer Energie von einem Netzanschlusspunkt (2) zu dem Multiphasenantrieb (10) mit einer Nennspannung von weniger als 100 V aufweist, wobei der Leitungsstreckenabschnitts (3) eine Länge von weniger als 2 m aufweist. Die Erfindung betrifft ferner ein Multiphasenantriebssystem (100), aufweisend eine derartige Energieversorgungsvorrichtung (1) und einen Multiphasenantrieb (10) mit einer Eingangsspannung von weniger als 100 V und einer Nennleistung von mehr als 300 kW, insbesondere von mehr als 1 MW. Weiter betrifft die Erfindung ein Schiff (20) mit einem derartigen Multiphasenantriebssystem (100).

## Beschreibung

Die Erfindung betrifft eine Energieversorgungsvorrichtung für einen Multiphasenantrieb, wobei der Multiphasenantrieb eine Eingangsspannung von weniger als 100 V und eine Nennleistung von mehr als 300 kW, insbesondere von mehr als 1 MW, aufweist. Ferner betrifft die Erfindung ein Multiphasenantriebssystem mit einer derartigen Energieversorgungsvorrichtung und einem Multiphasenantrieb. Die Erfindung betrifft weiter ein Schiff mit einem derartigen Multiphasenantriebssystem.

Derzeit sind am Markt eine Vielzahl elektrischer Maschinen verfügbar, die mit dreiphasigen Anschlüssen ausgebildet sind. Dabei sind die Statorstäbe derart verschaltet, dass diese Wicklungen bilden und mit den Phasenanschlüssen verbunden sind. Anstelle von Stäben kann der Stator auch durch parallel ausgerichtete Leiter, insbesondere Kupferleiter, in einer Nut gebildet werden. Im Folgenden umfasst die Bezeichnung der Stäbe auch die Ausgestaltung durch mehrere bzw. einer Vielzahl von Leitern in einer jeweiligen Nut.

Ein alternativer Aufbau einer elektrischen Maschine besteht darin, jeden Stab separat mit einem Stromrichtermodul zu speisen. Die Phasenzahl einer derartigen elektrischen Maschine entspricht damit der Anzahl der Nuten im Stator. Die für die Speisung der einzelnen Nuten vorgesehenen Stromrichtermodule bilden einen Stromrichter, der mit der elektrischen Maschine direkt verbunden ist und mit dieser eine Funktionseinheit bildet.

Eine derartige elektrische Maschine mit einem aus Stromrichtermodulen aufgebauten Stromrichter wird auch als Multiphasenantrieb bezeichnet. Seine Eingangsspannung bildet oftmals eine Gleichspannung.

Das für den Betrieb der elektrischen Maschine notwendige magnetische Feld wird durch hohe Ströme in den Statorstäben bei gleichzeitig vergleichsweise niedrigen Spannungen erzeugt. Bekannte Anwendungen in der Größenordnung von etwa 50 kW entnehmen dabei die für den Betrieb erforderliche Leistung direkt einer Batterie.

Der Erfindung liegt die Aufgabe zugrunde, die Energieversorgung eines leistungsfähigen Multiphasenantriebs zu verbessern.

Diese Aufgabe wird durch eine Energieversorgungsvorrichtung für einen Multiphasenantrieb gelöst, wobei der Multiphasenantrieb eine Eingangsspannung von weniger als 100 V und eine Nennleistung von mehr als 300 kW, insbesondere von mehr als 1 MW, aufweist, wobei die Energieversorgungeinrichtung einen Spannungsumformer aufweist, wobei die Energieversorgungsvorrichtung einen Leitungsstreckenabschnitt zur Übertragung von elektrischer Energie von einem Netzanschlusspunkt zu dem Multiphasenantrieb mit einer Nennspannung von weniger als 100 V aufweist, wobei der Leitungsstreckenabschnitts ein Länge von weniger als 2 m aufweist. Ferner wird diese Aufgabe durch ein Multiphasenantriebssystem mit einer derartigen Energieversorgungsvorrichtung und einem Multiphasenantrieb mit einer Eingangsspannung von weniger als 100 V und einer Nennleistung von mehr als 300 kW, insbesondere von mehr als 1 MW, gelöst. Diese Aufgabe wird weiter durch ein Schiff mit einem derartigen Multiphasenantriebssystem gelöst.

Weitere vorteilhafte Ausgestaltungen der Erfindung sind in den abhängigen Ansprüchen angegeben.

Der Erfindung liegt unter anderem die Erkenntnis zugrunde, dass sich ein Multiphasenantrieb anstelle aus einer Batterie auch verlustarm aus einem Energieversorgungsnetz mittels der vorgeschlagenen Energieversorgungsvorrichtung speisen lässt. Durch die geringe Spannung an den Stäben des Multiphasenantriebs ergeben sich für den geforderten Leistungsbereich entsprechend hohe Ströme. In einer typischen Anwendung beträgt diese Stabwechselspannung ca. 22 V bei ca. 600 A Stabwechselstrom. Die Versorgungsspannung des in dem Multiphasenantrieb integrierten Stromrichters auf der DC Seite, d.h. auf der Gleichspannungsseite, ergibt sich dann in etwa zu V_{DC} = 62 V. Das AC-Spannungsniveau an einem Netzanschlusspunkt eines Wechselspannungsnetzes zur Versorgung von elektrischen Antrieben liegt bei Niederspannung bei 690 V und für Hochspannung typischerweise bei 6 und 10 kV. Der Spannungswert kann aber auch jeden beliebigen Wert dazwischen, darunter oder darüber annehmen. Bei der Versorgung aus einem Gleichspannungsmetz erfolgt der Anschluss am Netzanschlusspunkt bei einer Spannung von vorzugsweise 690 V oder 5 kV. Auch jeder Wert dazwischen oder darüber sind möglich. Damit liegt die Spannung des Energieversorgungsnetzes am Netzanschlusspunkt erheblich über der Spannungsebene, mit welchem der Multiphasenantrieb gespeist wird.

Die geringen Spannungen des Multiphasenantriebs ergeben sich prinzipbedingt dadurch, dass die elektrische Maschine des Multiphasenantriebs durch die Speisung der einzelnen Stäbe im Stator mit einer halben Windung ausgeführt ist. Eine ganze Windung entspricht dabei eine Anordnung zweier Stäbe als Hin-und Rückleiter.

Ausgehend vom Netzanschlusspunkt des Energieversorgungsnetzes wird die Spannung am Netzanschlusspunkt mittels des Spannungsumformers auf eine niedrigere Spannung gewandelt, mit der der Multiphasenantrieb gespeist werden kann. Je nach Ausgestaltung des Energieversorgungsnetzes können als Spannungsumformer beispielsweise ein Transformator, ein Gleichspannungswandler oder ein Stromrichter zum Einsatz kommen. Der Stromrichter kann dabei eine Wechselspannung des Energieversorgungsnetzes in eine Gleichspannung zur direkten Speisung des Multiphasenantriebs umwandeln. Der Stromrichter kann dann auch als Gleichrichter bezeichnet werden.

Ein Gleichspannungswandler wird auch als Gleichspannungssteller, DC/DC Wandler oder DC/DC Steller bezeichnet.

Um die Energieversorgungsvorrichtung verlustarm zu gestalten, wird vorgeschlagen, den Leitungsstreckenabschnitt, der mit einer Spannung von weniger als 100 V betrieben wird, auf eine Länge von weniger als 2 m zu beschränken. Die mit den hohen Strömen einhergehenden Verluste können damit auf ein tolerierbares Maß reduziert werden. Bei den beiden Einheiten Multiphasenantrieb und Spannungsumformer handelt es sich um elektrische Komponenten, die zum einen aufgrund der rotierenden Teile bzw. den hohen Spannungen mit einem entsprechenden Gehäuse geschützt werden müssen. Der Leitungsstreckenabschnitt stellt die elektrische Verbindung oder zumindest einen Teil der elektrischen Verbindung zwischen diesen beiden Einheiten dar. Aufgrund der geringen Spannung dieser Verbindung müssen keine Maßnahmen hinsichtlich des Berührschutzes getroffen werden. Damit besteht eine sehr hohe Flexibilität in der Ausgestaltung dieser Verbindung. Diese können als Kabelverbindungen oder auch als eine Stromschiene ausgebildet sein. Dabei kann sich die Verbindung den Gegebenheiten anpassen, die sich aus der Aufstellung der beiden Einheiten, Multiphasenantrieb und Spannungsumformer, ergeben. Ein spezielles Gehäuse oder eine Abdeckung ist für den Leitungsstreckenabschnitt nicht erforderlich.

Das Bordnetz eines Schiffes ist oftmals als Mittelspannungsgleichspannungssystem ausgebildet. Daher eignet sich das Multiphasenantriebssystem im besonderen Maße für ein Schiff, da teilweise auf eine Umwandlung in eine andere Bordnetzspannung entfallen kann. Ist das Bordnetz des Schiffes hingegen beispielsweise auf eine Spannung von 690 V oder 5 kV ausgelegt, so kann eine Spannungsanpassung mit Hilfe eines Gleichspannungsstellers auf besonders einfache Weise erfolgen.

Die mit der vorgeschlagenen Lösung einhergehenden Vorteile im Multiphasenantriebssystem betreffen nicht nur die Energieversorgungsvorrichtung, sondern beziehen sich im Besonderen auch auf den Betrieb des Multiphasenantriebs. Eine vom Markt akzeptierte und für den Kunden attraktive Lösung ist ein positiver Effekt für den Erfolg des Multiphasenantriebs.

Die Energieversorgungsvorrichtung kann außerhalb des Multiphasenantriebs angeordnet sein. In diesem Fall erstreckt sich der Leitungsstreckenabschnitt bis zu den Anschlüssen des Multiphasenantriebs. Alternativ ist es möglich, die Energieversorgungsvorrichtung zumindest teilweise innerhalb des Multiphasenantriebs anzuordnen. In diesem Fall ist mindestens ein Spannungsumformer in dem Gehäuse des Multiphasenantriebs angeordnet. Dabei befindet sich dieser Spannungsumformer von den Anschlüssen des Multiphasenantriebs betrachtet auf der Seite der elektrischen Maschine. Dann erstreckt sich der Leitungsstreckenabschnitt bis zu den Stromrichtermodulen des Multiphasenantriebs. Der Leitungsstreckenabschnitt beginnt an dem Punkt, an dem die vorgesehene Spannung für den Leitungsabschnitt geringer ist als 100 V.

Bei einer vorteilhaften Ausgestaltung der Erfindung ist der Spannungsumformer als Transformator oder als Gleichspannungswandler ausgebildet. Der Transformator stellt bei der Versorgung aus einem Wechselspannungsnetz eine einfache und zuverlässige Möglichkeit dar, eine Wechselspannung zu verändern bzw. anzupassen. Aufgrund seines Eisenkerns hat der Transformator ein hohes Gewicht. Dies stellt eine besondere Anforderung an den Aufstellungsort, beispielsweise besondere Anforderungen an das Fundament, dar. Aufgrund dieser besonderen Anforderungen ist die Aufstellung des Transformators nicht besonders flexibel. Gerade durch den Leitungsstreckenabschnitt mit nur geringer Spannung, die keine besonderen Vorkehrungen zum Berührschutz bedarf, kann dieser Nachteil auf einfache Weise ausgeglichen werden, da mittels der Leitungsstreckenabschnitts der Transformator flexibel mit dem Multiphasenantrieb verbunden werden kann.

Bei einem Gleichspannungsnetz kann der Spannungsumformer als Gleichspannungswandler ausgebildet sein. Der Gleichspannungswandler wandelt dabei mittels Halbleiter eine erste Gleichspannung in eine zweite Gleichspannung kostengünstig und zuverlässig um. Der Gleichspannungswandler ist dabei unter anderem aus Gründen des Berührschutzes vorzugsweise in einem Schaltschrank angeordnet. Dabei kann der Gleichspannungswandler in räumlicher Nähe zum Netzanschlusspunkt angeordnet sein. Sollte sich dieser jedoch im größeren Abstand zum Multiphasenantrieb befinden, kann es vorteilhaft sein, den Gleichspannungswandler in der Nähe des Multiphasenantriebs anzuordnen, um die Leitungsstrecke, die mit geringer Spannung betrieben wird, möglichst gering zu halten. Mittels des Leitungsstreckenabschnittes wird die Energie von diesem Schaltschrank zum Multiphasenantrieb bei geringer Spannung und über eine geringe Entfernung übertragen.

Bei einer weiteren vorteilhaften Ausgestaltung der Erfindung ist der Leitungsstreckenabschnitt zumindest teilweise als Stromschiene ausgebildet. Stromschienen haben den Vorteil, auch hohe Querschnitte bereitstellen zu können, die eine hohe Stromtragfähigkeit bei niedrigen elektrischen Verlusten aufweisen. Sie eignen sich daher im Besonderen für die Ausgestaltung des Leitungsstreckenabschnitts. Gleichzeitig kann auf eine Isolierung zur Sicherstellung des Berührschutzes verzichtet werden, da die verwendete Spannung insbesondere im Hinblick auf den Berührschutz hinreichend klein ist. Dies ist ebenfalls vorteilhaft für die Anwendung der Stromschienen, da diese meistens keine Isolierung an ihrer Oberfläche aufweisen. Die nicht vorhandene Isolierung verbessert auch die Wärmeabfuhr, die durch die elektrischen Verluste entsteht. Die Wärme kann direkt vom Material der Stromschiene, vorzugsweise Kupfer, an die Umgebung abgeführt werden, ohne dass diese durch eine Isolationsschicht behindert werden. Somit stellt die Stromschiene gerade für die Anwendung in einer Energieversorgungsvorrichtung für den Multiphasenantrieb aufgrund der unterschiedlichen Vorteile eine besonders vorteilhafte Ausgestaltung des Leitungsstreckenabschnitts dar.

Bei einer weiteren vorteilhaften Ausgestaltung der Erfindung weist die Energieversorgungeinrichtung einen weiteren Spannungsumformer auf. Ist die zu überwindende Strecke zwischen Netzanschlusspunkt und Multiphasenantrieb groß, so kann mit einem weiteren Spannungsumformer ein weiteres Spannungsniveau für die Übertragung der elektrischen Energie erzeugt werden. Dabei kann der Spannungsumformer beispielsweise bei einem Betrieb an einem Wechselspannungsnetz als weiterer Transformator oder bei einem Betrieb an einem Gleichspannungsnetz als weiterer Gleichspannungswandler ausgebildet sein. Dabei kann für einen weiteren Leitungsabschnitt eine Spannung zwischen 100 V und 1000 V vorgesehen werden. Dieser weitere Leitungsabschnitt eignet sich insbesondere, eine Energieübertragung über eine Strecke von mehr als 2 m verlustarm auszuführen. Insbesondere erlaubt der weitere Leitungsabschnitt, die Länge des Leitungsstreckenabschnitts mit einer Spannung von weniger als 100 V auf eine Ausdehnung von weniger als 2 m zu begrenzen. Dazu werden die beiden Spannungsumformer an den beiden Enden des weiteren Leitungsabschnitts angeordnet.

Durch die Aufteilung in einen Leitungsstreckenabschnitt und einen weiteren Leitungsabschnitt kann die Energieversorgungsvorrichtung besonders vorteilhaft auf die Gegebenheiten am Installationsort angepasst werden. Dabei kann auch der Multiphasenantrieb entfernt vom Netzanschlusspunkt angeordnet werden. In der vorgeschlagenen Anordnung befinden sich die elektrischen Verluste in einem akzeptierbaren Maß. Darüber hinaus weisen auch die Übertragungswege keine Spannungen über 1000 V auf, bei denen der Aufwand für Isolierung zur Einhaltung des Berührschutzes überproportional ansteigen würden.

Durch den weiteren Spannungsumformer ist das Energieversorgungssystem besonders vorteilhaft und flexibel an die Gegebenheiten am Installationsort anpassbar.

Bei einer weiteren vorteilhaften Ausgestaltung der Erfindung weist die Energieversorgungsvorrichtung einen Gleichrichter auf. Zur Speisung des Multiphasenantriebs mit Gleichspannung ist es vorteilhaft, einen Gleichrichter in der Energieversorgungsvorrichtung anzuordnen. Mit diesem kann eine Wechselspannung, die am Netzanschlusspunkt vorliegt und ggf. über einen oder mehrere Spannungsumformer gewandelt wird, in eine Gleichspannung zur Speisung des Multiphasenantriebs umgewandelt werden. Damit ist der Multiphasenantrieb auch aus einem Wechselspannungsnetz mit einem hohen Wirkungsgrad speisbar.

Bei einer weiteren vorteilhaften Ausgestaltung der Erfindung weist die Energieversorgungsvorrichtung einen Gleichrichter auf, wobei der Gleichrichter und zumindest Teile des Multiphasenantriebs mit dem gleichen Kühlprinzip gekühlt werden. Auf einen in der Energieversorgungsvorrichtung angeordneten Gleichrichter kann verzichtet werden, wenn der Multiphasenantrieb in seiner Funktionseinheit bereits einen Gleichrichter umfasst. In diesem Fall ist der Multiphasenantrieb dann mit einer Wechselspannung speisbar. Darüber hinaus lässt sich der Gleichrichter wie der Stromrichter in das Gehäuse des Multiphasenantriebs integrieren. Insbesondere die Kühlung kann als gemeinsame Kühlung für Gleichrichter und Stromrichter ausgebildet sein. Dabei hat es sich auch als vorteilhaft erwiesen, wenn der Gleichrichter und zumindest Teile des Multiphasenantriebs wie beispielsweise der Stromrichter, mit der gleichen Kühlart, beispielsweise dem gleichen Luftstrom oder dem gleichen Fluidstrom, gekühlt werden.

Bei einer weiteren vorteilhaften Ausgestaltung der Erfindung sind der Spannungsumformer und der Leitungsstreckenabschnitt im Innern eines Gehäuses des Multiphasenantriebs angeordnet. In diesem Fall verhält sich die elektrische Maschine wie ein Motor mit einer Anschlussspannung von deutlich mehr als 100 V, beispielsweise einer Gleichspannung von 690 V oder einer Wechselspannung von über 1000 V. Der Multiphasenantrieb bildet dann eine bauliche Einheit, die den Spannungsumformer und den Leitungsstreckenabschnitt mit einer Spannung von weniger als 100 V umfasst. Die Spannungsumwandlung, beispielsweise durch einen Gleichspannungswandler oder einen Stromrichter erfolgt dann direkt im Gehäuse des Multiphasenantriebs. Damit kann auch der Spannungsumformer mit dem Kühlkreislauf des Multiphasenantriebs verbunden sein. Somit kann ein vorhandener Motor herkömmlicher Bauart auf einfache Weise durch das Multiphasenantriebssystem getauscht und ersetzt werden. Mit anderen Worten bildet das Multiphasenantriebssystem einen anschlusskompatiblen Ersatz für bestehende Motoren.

Im Folgenden wird die Erfindung anhand der in den Figuren dargestellten Ausführungsbeispiele näher beschrieben und erläutert. Es zeigen:
- FIG 1 bis FIG 4: Ausführungsbeispiele der Energieversorgungsvorrichtung und des Multiphasenantriebssystems und
- FIG 5 und FIG 6: Ausführungsbeispiele des Multiphasenantriebs.

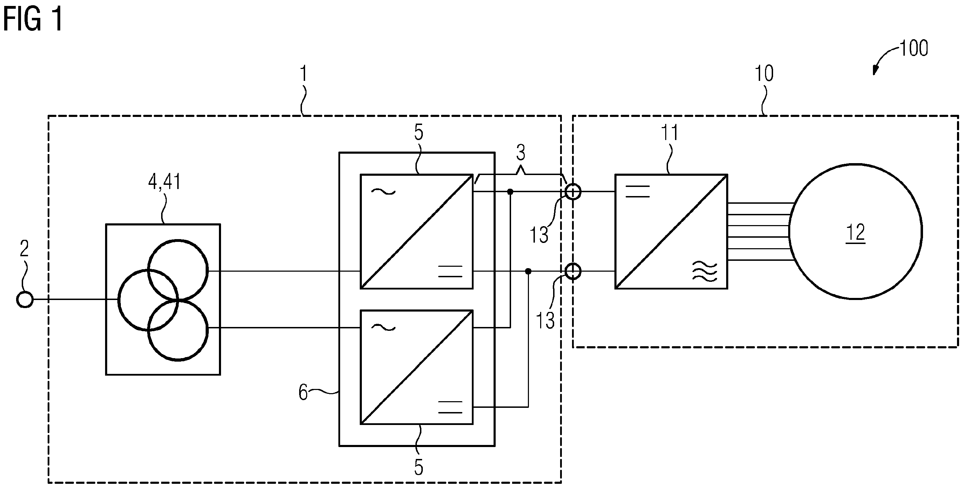

Die FIG 1 zeigt ein Multiphasenantriebssystem 100, das eine Energieversorgungsvorrichtung 1 und einen Multiphasenantrieb 10 aufweist. Die Energieversorgungsvorrichtung 1 überträgt elektrische Energie von einem Netzanschlusspunkt 2 eines Energieversorgungsnetzes an Anschlüsse 13 des Multiphasenantriebs 10. In diesem Ausführungsbeispiel wird dabei in einem ersten Schritt mittels eines Spannungsumformers 4, der als Transformator 41 ausgebildet ist, eine Wechselspannung an dem Netzanschlusspunkt 2 in der Amplitude verändert. Ein weiterer Spannungsumformer 6, in diesem Beispiel durch zwei parallel angeordnete Gleichrichter 5 gebildet, wandeln die durch den Transformator 41 gebildete Wechselspannung in eine Gleichspannung um, mit der der Multiphasenantrieb 10 gespeist wird. Dabei ist ein Leitungsstreckenabschnitt 3 zwischen dem Spannungsumformer 6 und den Anschlüssen 13 des Multiphasenantriebs 10 derart ausgebildet, dass die dort vorhandene Gleichspannung einen Wert von weniger als 100 V annimmt. Zudem ist die Länge des Leitungsstreckenabschnitts 3 geringer als 2 m, um die elektrischen Verluste gering zu halten.

Der Multiphasenantrieb 10 weist neben der elektrischen Maschine 12 Stromrichtermodule 11 auf, die die einzelnen Stäbe des Stators mit elektrischer Energie speisen. Die elektrische Energie wird dem Multiphasenantrieb 10 über die Anschlüsse 13 des Multiphasenantriebs 10 zugeführt.

Für die Betrachtung der durch die niedrige Spannung und den hohen Strömen verursachten Verluste wird die Strecke des Leitungsabschnitts zwischen den Anschlüssen 13 des Multiphasenantriebs 10 und den Stromrichtermodulen 11 des Multiphasenantriebs 10 aufgrund der geringen Ausdehnung vernachlässigt. Diese Ausdehnung ist deutlich geringer als die Länge des Leitungsstreckenabschnitts 3.

Die Vorteile dieser Anordnung liegen nun darin, mit den dargestellten Komponenten wie Transformator 41 und Gleichrichter 5 eine kostengünstige, zuverlässige Energieversorgungsvorrichtung 1 angeben und realisieren zu können. Dabei ist primärseitig der Transformator 41 an das beim Kunden verfügbare Spannungsniveau am Netzanschlusspunkt 2 anzupassen, d.h. die Primärwicklung ist für die jeweilige Versorgungsspannung von z.B. 10 kV, 6 kV oder 690 V auszulegen. Die Ausgangsspannung der Sekundärwicklung ist dagegen an die DC-Spannungsebene des Multiphasenantriebs 10 anzugleichen. Dabei kann der Gleichrichter 5 sowohl dem Transformator 41 wie auch dem Multiphasenantrieb 10 angegliedert oder in diesen integriert werden. Durch die prinzipbedingten hohen Ströme ist in beiden Fällen eine kurze Leitungsstrecken vom Transformator 41 zum Gleichrichter 5 (Gleichrichter 5 am/im Multiphasenantrieb 10) und/oder vom Gleichrichter 5 zum Multiphasenantrieb 10 (Gleichrichter 5 am/im Transformator 41) vorzusehen. Wichtig ist, dass der Leitungsstreckenabschnitt 3 mit einer Spannung von weniger als 100 V kurz, d.h. mit einer Länge von weniger als 2 m, ausgeführt wird. Idealerweise lassen sich die Komponenten Transformator 41, Gleichrichter 5 und Multiphasenantrieb 10 räumlich so anordnen, dass die hohen DC-Ströme mittels kurzer Stromschienen übertragen werden. Technisch ist diese Komponentenanordnung zu bevorzugen, da bei der Übertragung der DC-Ströme keine Maßnahmen zur Reduktion von Wechselstromverlusten in den Kabeln zu treffen sind. Die Baugröße des Gleichrichters 5 ist mit der Baugröße der Stromrichtermodule 11 in dem Multiphasenantrieb 10, beispielsweise aufgrund der ähnlichen Leistung, vergleichbar. Auch kann für den Gleichrichter 5 das gleiche Kühlprinzip angewendet werden.

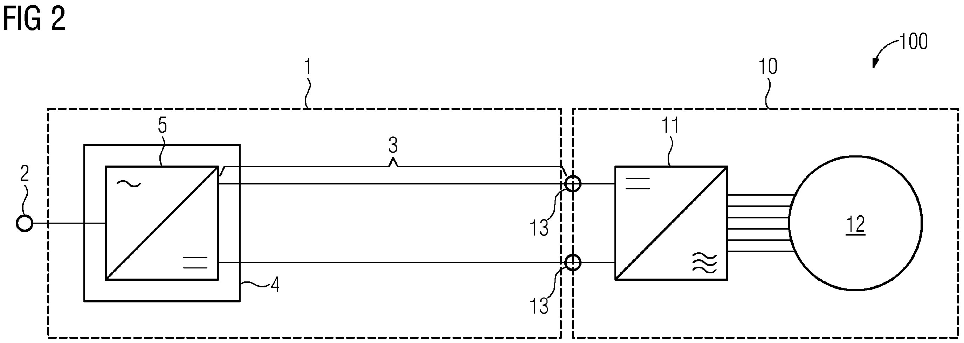

Die FIG 2 zeigt ein weiteres Ausführungsbeispiel eines Multiphasenantriebssystems 100 mit einer alternativ ausgeführten Energieversorgungsvorrichtung 1. Zur Vermeidung von Wiederholungen wird auf die Beschreibung zur FIG 1 sowie auf die dort eingeführten Bezugszeichen verwiesen.

Die Energieversorgungsvorrichtung 1 weist in diesem Ausführungsbeispiel im Wesentlichen nur den Spannungsumformer 4 auf, der beispielsweise als Gleichrichter 5 ausgebildet ist, falls am Netzanschlusspunkt 2 beispielsweise eine Wechselspannung anliegt. Dabei kann der Spannungsumformer 4 auch mehrere Gleichrichter 5 umfassen, die beispielsweise in einer Reihenschaltung und/oder Parallelschaltung angeordnet sind. Alternativ kann der Spannungsumformer 4 auch als Gleichspannungswandler 42 ausgebildet sein, falls am Netzanschlusspunkt 2 beispielsweise eine Gleichspannung anliegt. Von diesem Gleichrichter 5 wird die elektrische Energie mittels des Leitungsstreckenabschnitts 3 von weniger als 2 m verlustarm bei einer Gleichspannung von weniger als 100 V an die Anschlüsse 13 des Multiphasenantriebs 10 übertragen.

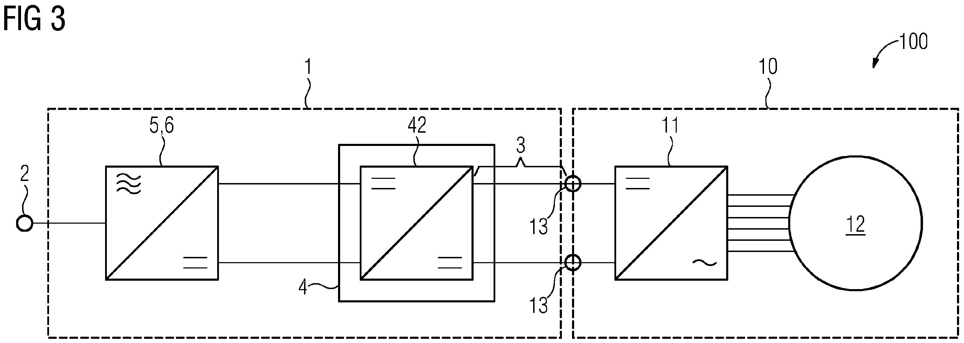

Die FIG 3 zeigt ein weiteres Ausführungsbeispiel eines Multiphasenantriebssystems 100 mit einer alternativ ausgeführten Energieversorgungsvorrichtung 1. Zur Vermeidung von Wiederholungen wird auf die Beschreibung zu den Figuren 1 und 2 sowie auf die dort eingeführten Bezugszeichen verwiesen.

In diesem Ausführungsbeispiel sind zwei Spannungsumformer 4,6 vorhanden. Dabei ist ein erster der Spannungsumformer 4 als Gleichspannungswandler 42 ausgebildet. Alternativ kann der Spannungsumformer 4 auch mehrere Gleichspannungswandler 42 aufweisen. Dieser wandelt eine Gleichspannung, die von einem weiteren Spannungsumformer 6 der zwei Spannungsumformer 4,6 erzeugt wurde, in eine niedrigere Spannung um, mit der der Multiphasenantrieb 10 betrieben wird.

Diese Anordnung bietet sich an, wenn zwischen dem Netzanschlusspunkt 2 und dem Multiphasenantrieb 10 ein größerer Abstand, insbesondere ein Abstand von mehr als 2 m, besteht. Dann kann zwischen dem Gleichrichter 5 und dem Gleichspannungswandler 42 Energie mit einer höheren Spannung über weitere Entfernung übertragen werden, bevor die Gleichspannung durch den Gleichspannungswandler 42 auf eine Spannung von weniger als 100 V herabgesetzt wird, mit der der Multiphasenantrieb 10 an seinen Anschlüssen 13 betrieben wird. Auch in diesem Fall kann sichergestellt werden, dass der Leitungsstreckenabschnitt 3 zwischen Gleichspannungswandler 42 und den Anschlüssen 13 des Multiphasenantriebs 10 mit einer Länge von maximal 2 m entsprechend kurz und verlustarm ausgeführt wird. Zusätzlich kann zwischen dem Gleichrichter 5 und dem Netzanschlusspunkt 2 auch noch ein Transformator 41 angeordnet werden.

Dabei kann der Transformator 41, nicht notwendigerweise, primärseitig an das beim Kunden verfügbare Spannungsniveau angepasst werden. Das heißt, die Primärwicklung wird für die jeweilige Versorgungsspannung von beispielsweise 10 kV, 6 kV oder 690 V ausgelegt. Auf der Sekundärseite des Transformator 41 ist der Gleichrichter 5, ausgeführt als Mittelspannungsgleichrichter, angeordnet. Dabei können in einer vorteilhaften Ausgestaltung Transformator 41 und Gleichrichter 5 eine bauliche Einheit bilden. Der nachgeschaltete Gleichspannungswandler 4,42, auch als DC-Transformer bezeichnet, übernimmt die Spannungsanpassung zwischen Mittelspannungsgleichrichter 5 und Multiphasenantrieb 10. Idealerweise kann der Gleichspannungswandler 42 unmittelbar an dem Multiphasenantrieb 10 positioniert werden. Damit lässt sich die elektrische Verbindung beispielsweise als Kabelverbindung vom Gleichrichter 5 zum Gleichspannungswandler 42 konventionell und ohne besondere räumliche Nähe ausführen.

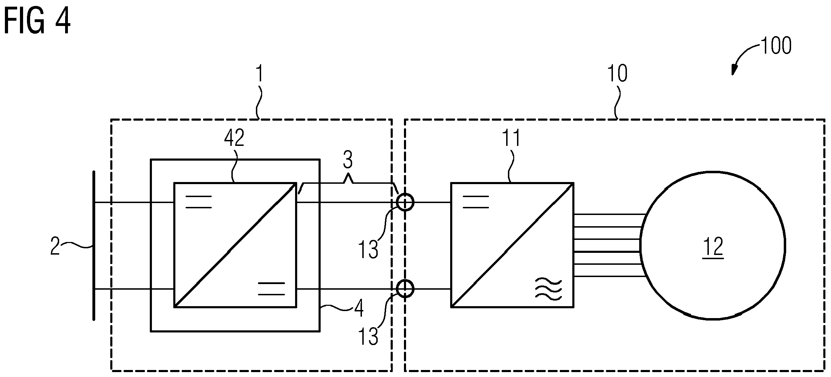

Die FIG 4 zeigt ein Multiphasenantriebssystem 100 mit einer Energieversorgungsvorrichtung 1, die mit einem Netzanschlusspunkt 2 verbunden ist, an dem eine Gleichspannung anliegt. In diesem Ausführungsbeispiel ist der Spannungsumformer 4 als Gleichspannungswandler 42 ausgebildet. Die Energieversorgungsvorrichtung 1 umfasst dabei neben dem Gleichspannungswandler 42 den Leitungsstreckenabschnitt 3, der den Gleichspannungswandler 42 elektrisch mit den Anschlüssen 13 des Multiphasenantriebs 10 verbindet. Der Leitungsstreckenabschnitt 3 weist eine Spannung von weniger als 100 V auf und ist aufgrund seiner Länge von weniger als 2 m verlustarm.

Die FIG 4 zeigt zudem, wie bei einem kundenseitig gegebenen Mittelspannungsnetz mit Gleichspannung am Netzanschlusspunkt 2 der Multiphasenantrieb 10 mit Energie versorgt werden kann. Vergleichend mit der Ausgestaltung nach FIG 3 entfällt der optionale Transformator 41 und Gleichrichter 5, ausgeführt als Mittelspannungsgleichrichter. Der Gleichspannungswandler 42 kann direkt zwischen Netzanschlusspunkt 2 und Multiphasenantrieb 10 angeordnet werden. Besonders bei Schiffsapplikationen sind diese für den Multiphasenantrieb 10 vorteilhaften Mittelspannungsnetze anzutreffen.

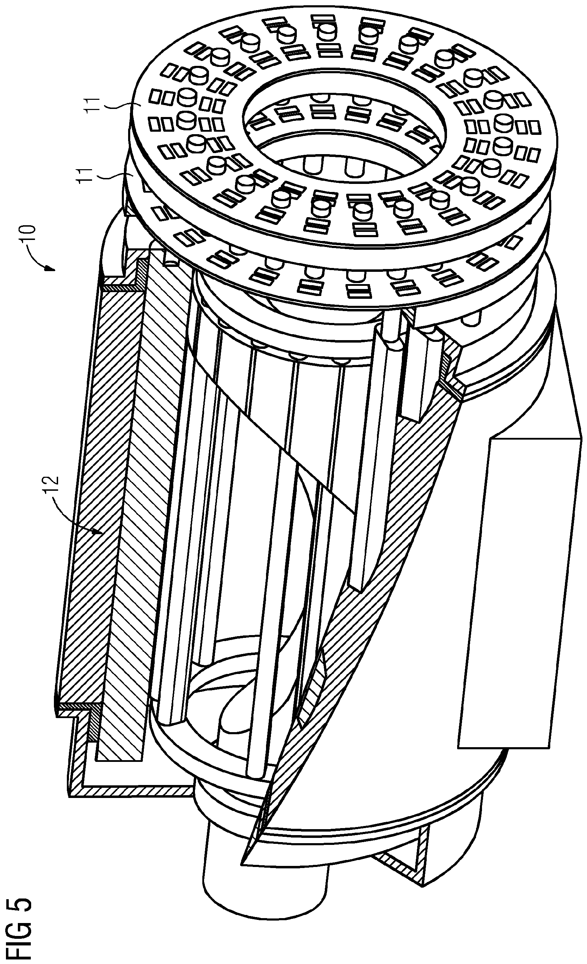

Die FIG 5 zeigt einen Multiphasenantrieb 10. Dieser weist neben der elektrischen Maschine 12 Stromrichtermodule 11 auf. Dabei sind die Stromrichtermodule 11 und die elektrische Maschine 12 in der baulichen Einheit des Multiphasenantriebs 10 angeordnet. Mittels Stromrichtermodule 11 wird jeder Stab des Stators der elektrischen Maschine 12 mit elektrischer Energie gespeist. Dabei ist der Multiphasenantrieb 10 derart ausgebildet, dass Spannung und/oder Strom jedes Stabes des Stators separat von einem der Stromrichtermodule 11 gesteuert oder geregelt werden kann.

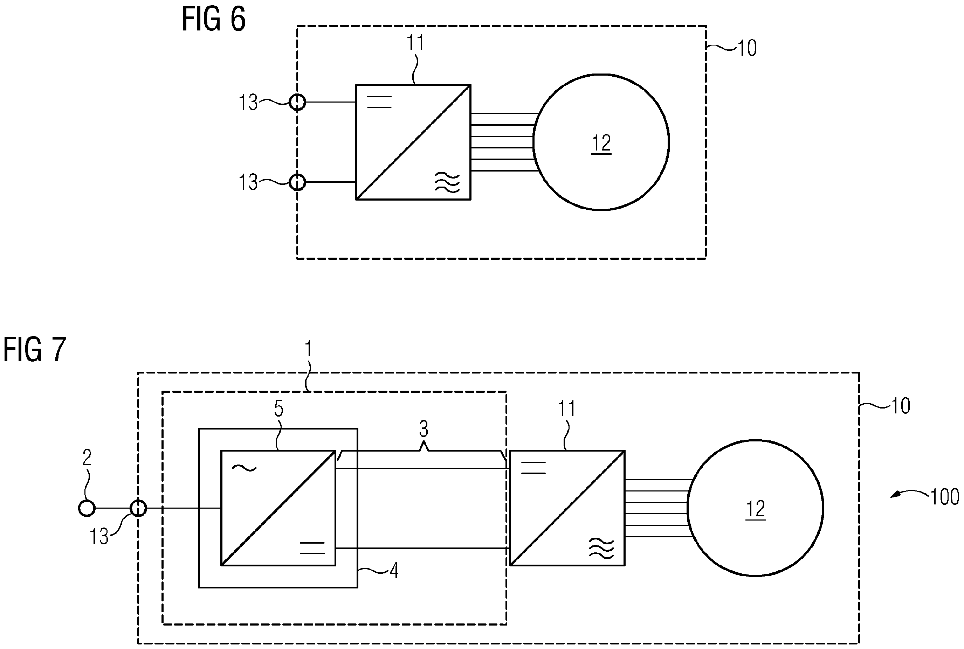

Die FIG 6 zeigt den schematischen Aufbau eines derartigen Multiphasenantriebs 10. An den vorzugsweise am Gehäuse angeordneten Anschlüssen 13 wird elektrische Energie den Stromrichtermodulen 11 zugeführt. Die Stromrichtermodule erzeugen für jeden Stab der elektrischen Maschine 12 die für die Regelung bzw. Steuerung benötigten Spannungen und/oder Ströme.

Die für den Betrieb des Multiphasenantriebs 10 benötigte Spannung beträgt weniger als 100 V.

Die FIG 7 zeigt ein weiteres Ausführungsbeispiel für den Aufbau eines Multiphasenantriebs 10. Zur Vermeidung von Wiederholungen wird auf die Beschreibung zu FIG 6 und auf die dort eingeführten Bezugszeichen verwiesen. In diesem Ausführungsbeispiel umfasst der Multiphasenantrieb 10 vollständig die Energieversorgungsvorrichtung 1. Mit anderen Worten ist die Energieversorgungsvorrichtung 1 ein Teil des Multiphasenantriebs 10. Der Netzanschlusspunkt 2 ist direkt mit den Anschlüssen 13 des Multiphasenantriebs 13 verbunden. Alternativ ist es auch möglich, dass ein hier nicht dargestellter weiterer Spannungsumformer zwischen dem Netzanschlusspunkt 2 und den Anschlüssen 13 des Multiphasenantriebs angeordnet ist. In diesem Fall der Multiphasenantrieb 10 die Energieversorgungsvorrichtung 1 nur teilweise.

Der Leitungsstreckenabschnitt 3 erstreckt sich in diesem Ausführungsbeispiel von dem Spannungsumformer 4, der als Gleichrichter 5 ausgebildet ist bis zu den Stromrichtermodulen 11 des Multiphasenantriebs 10.

Zusammenfassend betrifft eine Energieversorgungsvorrichtung 1 für einen Multiphasenantrieb 10, wobei der Multiphasenantrieb 10 eine Eingangsspannung von weniger als 100 V und eine Nennleistung von mehr als 300 kW, insbesondere von mehr als 1 MW, aufweist. Zur Verbesserung der Energieversorgung für einen derartigen Multiphasenantrieb 10 wird vorgeschlagen, dass die Energieversorgungeinrichtung 1 einen Spannungsumformer 4 aufweist, wobei die Energieversorgungsvorrichtung 1 einen Leitungsstreckenabschnitt 3 zur Übertragung von elektrischer Energie von einem Netzanschlusspunkt 2 zu dem Multiphasenantrieb 10 mit einer Nennspannung von weniger als 100 V aufweist, wobei der Leitungsstreckenabschnitts 3 eine Länge von weniger als 2 m aufweist. Die Erfindung betrifft ferner ein Multiphasenantriebssystem 100, aufweisend eine derartige Energieversorgungsvorrichtung 1 und einen Multiphasenantrieb 10 mit einer Eingangsspannung von weniger als 100 V und einer Nennleistung von mehr als 300 kW, insbesondere von mehr als 1 MW. Weiter betrifft die Erfindung ein Schiff 20 mit einem derartigen Multiphasenantriebssystem 100.

## Patentansprüche

1. Energieversorgungsvorrichtung (1) für einen Multiphasenantrieb (10), wobei der Multiphasenantrieb (10) eine Eingangsspannung von weniger als 100 V und eine Nennleistung von mehr als 300 kW, insbesondere von mehr als 1 MW, aufweist, wobei die Energieversorgungeinrichtung (1) einen Spannungsumformer (4) aufweist, wobei die Energieversorgungsvorrichtung (1) einen Leitungsstreckenabschnitt (3) zur Übertragung von elektrischer Energie von einem Netzanschlusspunkt (2) zu dem Multiphasenantrieb (10) mit einer Nennspannung von weniger als 100 V aufweist, wobei der Leitungsstreckenabschnitts (3) eine Länge von weniger als 2 m aufweist.

2. Energieversorgungsvorrichtung (1) nach Anspruch 1, wobei der Spannungsumformer (4) als Transformator (41) oder als Gleichspannungswandler (42) ausgebildet ist.

3. Energieversorgungsvorrichtung (1) nach einem der Ansprüche 1 oder 2, wobei der Leitungsstreckenabschnitt (3) zumindest teilweise als Stromschiene ausgebildet ist.

4. Energieversorgungsvorrichtung (1) nach einem der Ansprüche 1 bis 3, wobei die Energieversorgungeinrichtung (1) einen weiteren Spannungsumformer (6) aufweist.

5. Energieversorgungsvorrichtung (1) nach einem der Ansprüche 1 bis 4, wobei die Energieversorgungsvorrichtung (1) einen Gleichrichter (5) aufweist.

6. Multiphasenantriebssystem (100), aufweisend eine Energieversorgungsvorrichtung (1) nach einem der Ansprüche 1 bis 5 und einen Multiphasenantrieb (10) mit einer Eingangsspannung von weniger als 100 V und einer Nennleistung von mehr als 300 kW, insbesondere von mehr als 1 MW.

7. Multiphasenantriebssystem (100) nach Anspruch 6, wobei die Energieversorgungsvorrichtung (1) einen Gleichrichter (5) aufweist, wobei der Gleichrichter (5) und zumindest Teile des Multiphasenantriebs (10) mit dem gleichen Kühlprinzip gekühlt werden.

8. Multiphasenantriebssystem (100) nach einem der Ansprüche 6 oder 7, wobei der Spannungsumformer (4) und der Leitungsstreckenabschnitt (3) im Innern eines Gehäuses des Multiphasenantriebs (10) angeordnet sind.

9. Schiff (20) mit einem Multiphasenantriebssystem (100) nach einem der Ansprüche 6 bis 8.
